Europäisches Patentamt

European Patent Office

Office européen des brevets

(19)

(11) Publication number: **0 030 476**
B1

(12) **EUROPEAN PATENT SPECIFICATION**

(45) Date of publication of patent specification: **05.10.83**

(51) Int. Cl.³: **H 01 L 31/02, H 01 L 27/14**

(21) Application number: **80304441.1**

(22) Date of filing: **09.12.80**

(54) Solid state color imager and method of manufacturing the same.

(30) Priority: **10.12.79 JP 169848/79 U**

(43) Date of publication of application:
**17.06.81 Bulletin 81/24**

(45) Publication of the grant of the patent:
**05.10.83 Bulletin 83/40**

(84) Designated Contracting States:
**DE FR GB NL**

(56) References cited:
**FR - A - 2 449 974**
**US - A - 3 623 794**
**US - A - 4 168 448**

(73) Proprietor: **Hitachi, Ltd.**
**5-1, Marunouchi 1-chome**
**Chiyoda-ku Tokyo 100 (JP)**

(72) Inventor: **Sasano, Akira**
**2196-450, Hirai Hinodemachi Nishitama-gun**
**Tokyo (JP)**
Inventor: **Nakano, Toshio**
**2196-375, Hirai Hinodemachi Nishitama-gun**
**Tokyo (JP)**
Inventor: **Tsutsui, Ken**
**2-32-D102, Koyasu-cho Hachioji-shi**
**Tokyo (JP)**
Inventor: **Hashimoto, Michiaki**
**324-4-1-2004, Kami-ochiai**
**Yono-shi Saitama-ken (JP)**
Inventor: **Kaneko, Tadao**
**2196-121, Hirai Hinodemachi Nishitama-gun**
**Tokyo (JP)**
Inventor: **Taniguchi, Yoshio**
**1-4-30, Higashi-hirayama Hino-shi**
**Tokyo (JP)**
Inventor: **Matsumaru, Haruo**
**2196-4, Hirai Hinodemachi Nishitama-gun**
**Tokyo (JP)**
Inventor: **Izumi, Akiya**
**2705-3, Kobayashi**
**Mobara-shi Chiba-ken (JP)**

Courier Press, Leamington Spa, England.

**0 030 476**

2

(74) Representative: **Jackson, John Timothy et al,
MEWBURN ELLIS & CO. 2/3 Cursitor Street
London EC4A 1BQ (GB)**

## Solid state color imager and method of manufacturing the same

This invention relates to solid-state color imagers provided with color filters.

Recently, as video tape recorders (VTRs) for industrial or domestic use have come into wide use, the demand for television cameras which are small in size, light in weight and easy to handle has risen. Therefore, attention has been paid to solid-state television cameras employing semiconductor integrated circuits (in general, IC or LSI). In a solid-state television camera, the faceplate and the electron beam generating portion of a conventional image pickup tube are substituted by an IC body which forms an independent solid-state imager. Since the solid-state television camera uses no electron beam, it is superior to the image pickup tube in that it has high stability, low power dissipation, convenient handling, etc., and it is expected to be the television camera of the coming generation.

The solid-state imager has a color filter portion stacked on a semiconductor body portion.

When complementary color filters are used, it is common practice to employ a system in which colors are reproduced with the four sets of cyan, yellow, green and white. In that case, green is produced by overlapping parts of cyan and yellow filters.

In general, the filters are made of an organic material such as gelatine and polyvinyl alcohol. The material is applied onto the semiconductor body, and it is exposed to light through a mask and then developed to produce the required pattern. Thereafter, the dye accepting material for the filter is dyed by immersing it in a predetermined dye liquor. After the filter of the first color has been formed, it is covered with an organic material which is not dyed with a dye liquor, and the same steps are repeated, whereby the filter of the second color is formed.

In this case, the spectral transmittance of the filter varies greatly depending upon the thickness of the layer of the dye accepting material used to make it. In order to realize a good color filter, accordingly, the layer of the filter dye accepting material needs to be formed to a precise thickness. However, where the layer of the filter dye accepting material is produced by utilizing photosensitivity of the filter dye accepting material as described above, the thickness of the layer of the filter dye accepting material is determined by the quantity of light to which it is exposed to form the pattern.

Where the color filter portion is formed directly on the solid-state imager by such method, reflected light from the surface of a substrate is a serious problem, in contrast to the formation of ordinary color filters. This is because the substrate of the solid-state imager reflects a large quantity of light unlike a transparent substrate of glass or the like.

When performing the exposure on the solid-state imager, the quantity of light in the exposure is determined by the sum of light entering directly from a light source and light reflected from the substrate surface. Accordingly, when the first color filter absorbs light such as ultraviolet radiation (for example, a yellow filter) and the second color filter above the first color filter is cyan the filter dye accepting material for cyan receives a smaller quantity of light in its part overlying the yellow filter than in its other part, on the supposition that the underlying substance is Si. When the filter dye accepting material, for example gelatine, is saturated with light, a pattern of high precision cannot be formed on account of increased fogging. It is accordingly the most suitable to expose the dye accepting material to a quantity of light just below saturation. At this time, in the above example, the thickness of the layer of gelatine differs by about 30% between the part overlying the yellow filter and the other part. As a result, the spectral transmittance of the color filter has a characteristic curve whose longer wavelength side is further shifted towards longer wavelengths. That is, a spectral transmittance in which green is shifted towards the longer wavelengths is obtained. With the color filter having such spectral transmittance, imaging results in a picture of extremely inferior color reproducibility.

An example in which filters are formed directly on a semiconductor substrate having photosensitive portions is known from "Technical Digest of International Electron Device Meeting," December 1976, p. 400.

In one aspect, this invention provides a solid-state color imager having a semiconductor body which includes a plurality of sets of photosensitive regions therein, and at least first and second color filter members which are arranged on the semiconductor body in correspondence with the photosensitive regions, the color filter members having at least two sorts of spectral transmittances different from each other and being stacked one above another to produce a third spectral transmittance, corresponding to one of the photosensitive regions in each set, by combining the spectral transmittances of the first and second filter members, a photographic exposure being used in the formation of the filter members; characterized in that, in stacking said first and second filter members, one of said filter members the spectral transmittance of which substantially transmits light used for said exposure is arranged as a lower layer of the stacked structure.

In a second aspect, this invention provides a method of manufacturing a solid-state color imager, including forming at least two color filter members on a semiconductor body having a plurality of sets of photosensitive regions, a photographic exposure process being used in the formation of the filter members, the filter members being given respective different spectral transmittances and being formed in an at least partially overlapping relationship whereby to produce a third spectral transmittance, corresponding to one of the photosensitive regions, by combining the spectral transmittances of said two filter members; characterized in that one of said filter members the spectral transmittance of which substantially transmits light used for said exposure is formed before the other filter member so as to be arranged as the lower of the two filter members in the overlapping region.

In general, the filter member of the first color may be formed by forming a photosensitive film by coating the body for the solid-state imager with a photosensitive solution, such as gelatine or the like which has been endowed with a photosensitivity, whereupon the photosensitive film is exposed to light by a mask exposure and then developed. Subsequently, this filter member is dyed and is covered with a transparent intermediate layer, and the same steps as described above are repeated, whereby the filter member of the second color is formed. (Such processes for forming filter members have been disclosed in Japanese Patent Applications Nos. 54-126844 and 54-107262).

In the drawings:

Figures 1a to 1c are sectional views of a solid-state imager showing the manufacturing steps of the imager,

Figure 2 is an enlarged sectional view of a picture element portion,

Figure 3 is a graph showing the spectral transmission factors of filters, and

Figure 4 is a sectional view of an imager showing another embodiment.

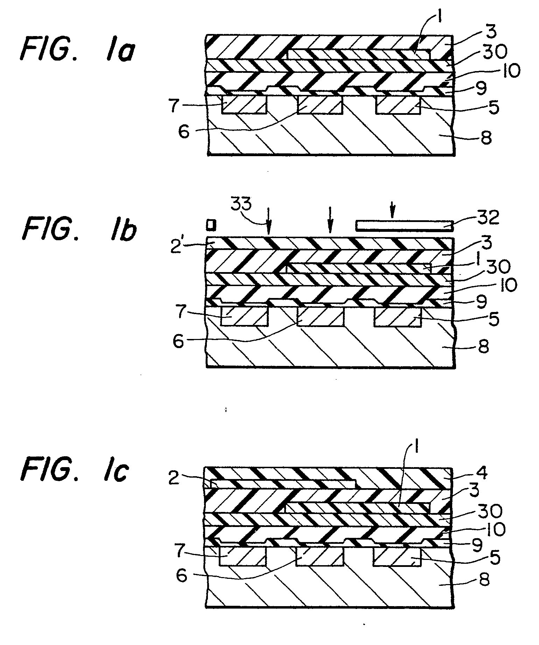

Figure 1c is a schematic sectional view of a solid-state color imager which is an embodiment of this invention.

Photosensitive regions 5, 6 and 7 of n-conductivity type which are 0.1—2 $\mu$m thick are formed in a Si substrate 8 of p-conductivity type. Further, an oxide film 9 which is 500 nm (5,000 Å)—1 $\mu$m thick is formed on the substrate 8 and the photosensitive regions 5—7. On the resultant semiconductor body, an insulating layer 10 made of silicon dioxide (SiO$_2$) is formed as a passivation film to a thickness of 0.5—2 $\mu$m. The passivation layer 10 is overlaid with a protection layer 30 which is made of a polymer resin, suitably polyglycidyl methacrylate (abbreviated to "PGMA") and which is 0.5—1 $\mu$m thick. This forms the semiconductor body for the solid-state color imager. Further, a cyan color filter member 1 which is 0.5—1 $\mu$m thick and which has a predetermined pattern is formed on that area of the protection layer 30 which corresponds to the photosensitive regions 5 and 6. A color mixture-preventive protection layer 3 which is 0.5—1 $\mu$m thick is formed around and on the filter member 1. This protection layer 3 is usually termed an "intermediate layer". Further, a yellow color filter member 2 which is 0.5—1 $\mu$m thick and which has a predetermined pattern is formed on that area of the color mixture-preventive protection layer 3 which corresponds to the photosensitive regions 6 and 7. A protection layer 4 which is 0.5—1 $\mu$m thick is formed around and on the filter member 2. If necessary, an antireflection layer may well be formed on the protection layer, though this is not shown in the Figure.

As described above, just the cyan color filter member 1 is disposed over the photosensitive region 5 corresponding to the color cyan. Over the photosensitive region 6 corresponding to the color green, both the cyan color filter member 1 and the yellow color filter member 2 are disposed in an overlapping fashion. Over the photosensitive region 7 corresponding to the color yellow is disposed just the yellow color filter member 2.

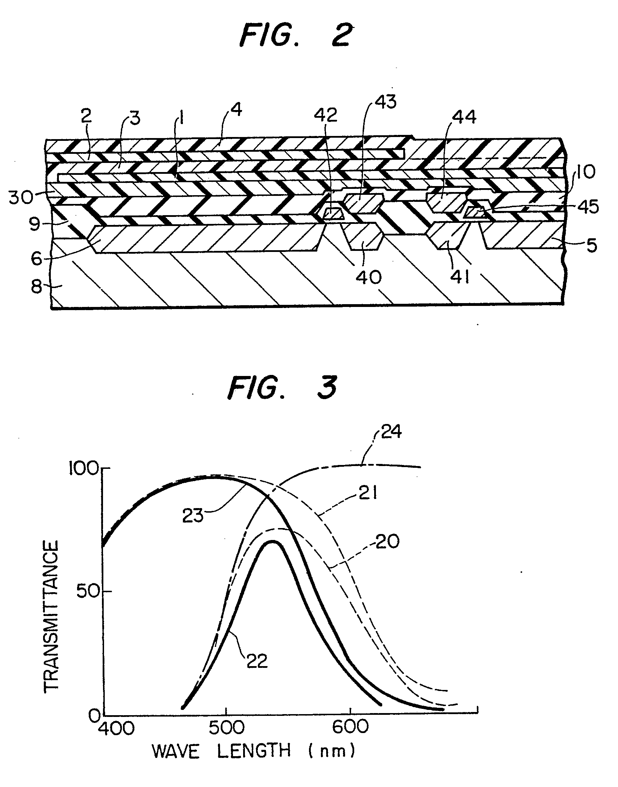

Figure 2 is a partial enlarged view of and near the photosensitive region 6 for green in Figure 1c. The switching portions of MOS type transistors are also shown. The same numerals as in Figure 1c indicate the same parts. Numerals 40 and 41 designate drains for signal outputs of the color green and the color cyan respectively, numerals 43 and 44 signal output lines, and numerals 42 and 45 gates. The MOS type transistor portions are quite the same as conventional ones.

Figure 3 is a graph showing the spectral transmission factors of color filters, and illustrates for comparison's sake the color filters of an embodiment of this invention and of a device not incorporating the present invention. The abscissa axis represents the wavelength of light, while the ordinate axis represents the transmittance in percent.

A curve 23 indicates the spectral transmission factor of a cyan color filter, and a curve 24 that of a yellow color filter. Now, let's consider a case where a yellow color filter member is formed as a lower layer and a cyan color filter member as an upper layer and where the overlapping parts of the color filter members are used for green. The exposure for forming the filter members is usually performed using ultraviolet radiation or visible rays (for example light of a wavelength of 435 nm within the visible region). In this case, the yellow color filter member does not transmit the exposure light because of its spectral transmittance. Accordingly, the layer of the cyan color filter member arranged above it for obtaining a composite green color filter members becomes thin. As a result, the spectral transmission factor of the cyan color filter member will be as indicated by a curve 21. In consequence, the green color filter member composed of the yellow color filter member indicated by the curve 24 and the cyan color filter member indicated by the curve 21 exhibits a spectral transmission factor as shown at a curve 20.

In this case, the part of the cyan color filter member for obtaining the cyan color has the characteristic of the curve 23 in Figure 3, whereas the part thereof arranged for obtaining the color green has the characteristic of the curve 21.

In reproducing the colors, the following subtractive color mixture of the three primary colors is relied on:

Cy (cyan)=B (blue)+G (green)
Ye (yellow)=G (green)+R (red)
G (green)

As stated above, however, green which is one of the three primary colors presents the characteristic which cannot be matched with the other primary colors. Accordingly, when the subtractive color mixture is executed, the colors R, G and B cannot be displayed as desired.

On the other hand, if, in accordance with this invention, the cyan color filter member transmitting the exposure light is disposed as the lower layer and the yellow color filter member is disposed as the upper layer so as to obtain the green color filter member, this green color filter member possesses a characteristic curve 22 in Figure 3.

If the cyan color filter member is arranged as the lower layer, the dye accepting material for the filter member to overlie the cyan color filter member is subjected to a predetermined exposure. It is then possible to form a filter member having a desired thickness. As a result, not only the part of the cyan color filter member for presenting the color cyan, but also the part thereof for obtaining the color green has the characteristic of the curve 23 in Figure 3. Accordingly, the combined green color filter member has the desired characteristic of the curve 22.

That is, by arranging as the lower layer the filter member which substantially transmits the exposure light, the thickness of the layer of the filter member to be formed overlapping the lower layer filter member can be more exactly controlled.

If the filter member transmits at least 50% of the exposure light, it can achieve an effect to that extent.

In the above, the primary colors in the subtractive color mixture employing cyan and yellow have been exemplified. However, it goes without saying that the present invention is effective also in case of producing a third color by combining color filters of other colors.

For manufacturing the color filters, the fundamentals of the prior art method can be satisfactorily employed as they are.

Figures 1a—1c show schematic process diagrams of a manufacturing method.

As shown in Figure 1a, over a semiconductor substrate 8 for a solid-state imager having at least photosensitive regions 5, 6 and 7, a protection layer 30 is formed of polyglycidyl methacrylate or the like to a thickness of 0.5—1 $\mu$m. An oxide layer 9 and an inorganic material layer 10 which serve for passivation are as explained before.

A photosensitive solution in which polyvinyl alcohol, glue, gelatine or the like is endowed with a photosensitivity is uniformly applied onto the protection layer 30, and it is dried to form a photosensitive film to a thickness of 0.5 to 1 $\mu$m. Spin coating suffices for the application of the photosensitive solution. Subsequently, that part of the photosensitive film which corresponds to the region which is to be photosensitive to the color cyan (being a first color) and the region which is to be photosensitive to the color green is photo-hardened by the mask exposure process, it is developed, and the other part of the photosensitive film is removed. The exposure is carried out with, for example, light having a wavelength of 435 nm. The resultant layer is dyed with a dye liquor having a predetermined spectral transmittance (an aqueous solution containing 2.2% of "Cibacron Turquoise blue"), and the resulting cyan color filter member 1 is covered with a transparent intermediate layer 3. Subsequently, in a similar manner to the above, as shown in Figure 1b, the photosensitive solution is uniformly applied to form a photosensitive film 2', whereupon it is exposed to the light by the mask exposure technique and then developed so as to form a portion extending over the region which is to be photosensitive to the color yellow and the region which is to be photosensitive to the color green. Numeral 32 in Figure 1b indicates a mask for the exposure, and numeral 33 the light for the exposure. That part of the photosensitive film 2' which overlies the yellow photosensitive region 7 is exposed to the direct light from the exposure light source and to reflected light from the surface of the semiconductor body. That part of the photosensitive film 2' which corresponds to the green photosensitive region 6 is similarly exposed to the direct light and the reflected light from the semiconductor body surface. More specifically, when the reflected light is considered, the cyan filter intervenes between the photosensitive film 2' and the semiconductor body surface. Since the cyan filter transmits the exposure light satisfactorily in practical use, the photosensitive layer 2' is exposed to the light substantially uniformly over the parts corresponding to the photosensitive regions 7 and 6. Accordingly, the photosensitive layer 2' when developed has a substantially uniform thickness.

Subsequently, the developed layer for a yellow color filter member 2 is dyed with a dye liquor having a predetermined spectral transmittance (an aqueous solution containing 0.7% of "Kayanol Yellow" (trade name)), and the yellow color filter member 2 is covered with a protection layer 4 (refer to Figure 1c).

Owing to this stacked structure in which the yellow color filter member 2 is formed over the cyan color filter member 1, the light for the exposure can be used without substantial attenuation thereof taking place even when the color filter members have overlapping parts.

In addition, since the reflected light from the substrate can also be effectively used for the exposure, the quantity of light which enters directly need not be increased unnecessarily. This is convenient for preventing the occurrence of fogging, and permits the formation of a pattern of high precision.

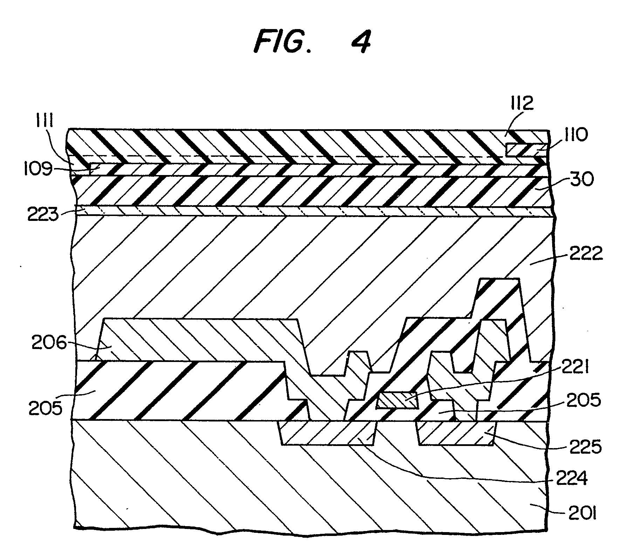

Figure 4 is a schematic sectional view of one picture element portion of a solid-state imager forming another embodiment of this invention.

This solid-state imager employs a photoconductive thin film as a photosensitive portion. A Si substrate 201 has impurity regions 224 and 225 formed therein, on which a gate electrode 221 is arranged in an insulating film 205.

A large number of switching elements thus constructed are arranged in a plane. A photoconductive thin film 222 is disposed over the switching elements, and is overlaid with a transparent electrode 223.

This invention is quite similarly applicable to such a solid-state imager which includes a switching circuit on the Si substrate made up of the switching elements formed of PN-junctions, the photoconductive thin film made of chalcogen glass or the like providing photoelectric conversion elements.

Shown at 206 is an electrode which is connected to the source of the vertical MOS switch. The photoconductive thin film 222 is conductive to the electrode 206, but it is insulated from the gate electrode 221 through the oxide film 205. The diffused layer 224 serves to lead out the electrode 206, and corresponds to the source of the vertical MOS switch. The electrode 206 forms a capacitance proportional to its area between it and the transparent conductive thin film 223 through the photoconductive thin film 222. Since the electrode pattern is separated into the shape of a matrix, such capacitances are arranged in the shape of the matrix. Since the capacitances include the photoconductive thin film therein, they function as photosensitive elements and form picture elements.

For the photoconductive thin film, substances exhibiting photoconductivities such as Se-Te-As amorphous semiconductors, $Sb_2S_3$, CdS, $As_2Se_3$ and polycrystalline Si and amorphous hydrogenated Si may be employed.

Color filters to be placed directly on the semiconductor body in such a solid-state imager can be constructed in quite the same way as in the foregoing examples.

Numeral 30 designates a protection layer as described before, numeral 109 a filter member of, e.g. the color cyan, numeral 110 a filter member of the color yellow, numeral 111 an intermediate layer, and numeral 112 a protection film of the uppermost layer.

The method of manufacturing the filters is quite the same as in the foregoing examples, and will not be repeated.

**Claims**

1. A solid-state color imager having a semiconductor body which includes a plurality of sets of photosensitive regions (5, 6, 7; 222) therein, and at least first and second color filter members (1, 2; 109, 110) which are arranged on the semiconductor body in correspondence with the photosensitive regions, the color filter members having at least two sorts of spectral transmittances (23, 24) different from each other and being stacked one above another to produce a third spectral transmittance (22), corresponding to one of the photosensitive regions (6) in each set, by combining the spectral transmittances of the first and second filter members, a photographic exposure being used in the formation of the filter members; characterized in that, in stacking said first and second filter members, one of said filter members (1) the spectral transmittance (23) of which substantially transmits light (33) used for said exposure is arranged as a lower layer of the stacked structure.

2. A solid-state color imager according to claim 1, wherein the light (33) used for said exposure is substantially ultraviolet radiation, and said filter member (1) arranged as said lower layer has a spectral transmittance (23) which substantially transmits the ultraviolet radiation.

3. A solid-state color imager according to claim 2, wherein a cyan filter member (1) is arranged as said lower layer and has a spectral transmittance (23) which substantially transmits the ultraviolet radiation, while a yellow filter member (2) is arranged as an upper layer.

4. A solid-state color imager according to any one of claims 1 to 3, wherein said plurality of sets of photosensitive regions included in said semiconductor body are constructed as a plurality of sets of impurity regions (5, 6, 7) which are disposed in a semiconductor substrate (8).

5. A solid-state color imager according to any of claims 1 to 3, wherein said plurality of sets of photosensitive regions included in said semiconductor body have a photoconductive layer (222) which is disposed on a semiconductor substrate (201).

6. A solid-state color imager according to any one of the preceding claims, wherein a light-transmitting polymer resin layer (30) is disposed on an upper surface of said semiconductor body and is overlaid with at least the color filter members (1, 2; 109, 110).

7. A method of manufacturing a solid-state color imager, including forming at least two color filter members (1, 2; 109, 110) on a semiconductor body having a plurality of sets of photosensitive regions (5, 6, 7; 222), a photographic exposure process being used in the formation of the filter members, the filter members being given respective different spectral transmittances (23, 24) and being formed in an at least partially overlapping relationship whereby to produce a third spectral transmittance (22), corresponding to one of the photosensitive regions (6), by combining the spectral transmittances of said two filter members; characterized in that one of said filter members (1) the spectral transmittance (23) of which substantially transmits light (33) used for said exposure is formed before the other filter member (2) so as to be arranged as the lower of the two filter members in the overlapping region.

8. A method of manufacturing a solid-state color imager including the steps of forming a photosensitive film for a color filter member on a semiconductor body including a plurality of sets of photosensitive regions (5, 6, 7; 222), exposing a desired area of the photosensitive film to light (33) and then developing it into a layer (1, 2; 109, 110) in a desired shape for the color filter member, endowing the layer for the color filter member with a predetermined spectral transmittance (23) to finish the color filter member, and covering the color filter member with a light-transmitting intermediate layer (3; 111) the operations being repeated to successively form color filter members (1, 2; 109, 110) which have predetermined respective spectral transmittances (23, 24), a protective layer (4, 112) being disposed as an uppermost layer, the respective spectral transmittances of at least two of the color filter members being different from each other, the color filter member having the first spectral transmittance being overlaid with the color filter member having the second spectral transmittance, a third spectral transmittance being produced by a combination of the first and second spectral transmittances; characterised in that, in stacking said first and second filter members (1, 2; 109, 110), one of the filter members (1, 109) having a spectral transmittance (23) which substantially transmits the light (33) used for the exposure is arranged as a lower layer of the stacked structure.

9. A method of manufacturing a solid-state color imager according to claim 7 or claim 8 wherein said light (33) for exposure is substantially ultraviolet radiation, and said filter member (1, 109) arranged as said lower layer has a spectral transmittance (23) which substantially transmits the ultraviolet radiation.

10. A method of manufacturing a solid-state color imager according to claim 9, wherein a cyan filter member (1, 109) is arranged as said lower layer and has a spectral transmittance (23) which substantially transmits the ultraviolet radiation, while a yellow filter member (2, 110) is arranged as an upper layer.

**Patentansprüche**

1. Festkörper-Farbbildaufnahmeeinrichtung mit einem Halbleiterkörper, der mehrere Gruppen lichtempfindlicher Bereiche (5, 6, 7; 222) enthält, und mindestens einem ersten und einem zweiten Farbfilterelement (1, 2; 109, 110), die entsprechend den lichtempfindlichen Bereichen auf dem Halbleiterkörper angeordnet sind, wobei die Farbfilterelemente mindestens zwei voneinander verschiedene Arten von spektralen Transmissionsfunktionen (23, 24) aufweisen und übereinander gestapelt sind, um durch Kombination der spektralen Transmissionsfunktionen des ersten und des zweiten Filterelements entsprechend jeweils einem der lichtempfindlichen Bereiche (6) in jeder Gruppe eine dritte spektrale Transmissionsfunktion (22) zu erzeugen, und wobei bei der Ausbildung der Filterelemente mit einer photographischen Belichtung gearbeitet wird; dadurch gekennzeichnet, daß beim Stapeln des ersten und des zweiten Filterelements eines dieser Filterelemente (1), dessen spektrale Transmissionsfunktion (23) für die Belichtung verwendetes Licht (33) im wesentlichen transmittiert, als untere Schicht des gestapelten Aufbaus angeordnet ist.

2. Festkörper - Farbbildaufnahmeeinrichtung nach Anspruch 1, wobei das für die Belichtung benutzte Licht (33) im wesentlichen ultraviolette Strahlung ist und das als untere Schicht angeordnete Filterelement (1) eine spektrale Transmissionsfunktion (23) aufweist, die ultraviolette Strahlung im wesentlichen transmittiert.

3. Festkörper - Farbbildaufnahmeeinrichtung nach Anspruch 2, wobei als untere Schicht ein Cyan-Filterelement (1) angeordnet ist, das eine die ultraviolette Strahlung im wesentlichen transmittierende spektrale Transmissionsfunktion (23) aufweist, während als obere Schicht ein Gelb-Filterelement (2) angeordnet ist.

4. Festkörper - Farbbildaufnahmeeinrichtung nach einem der Ansprüche 1 bis 3, wobei die besagten in dem Halbleiterkörper enthaltenen mehreren Gruppen von lichtempfindlichen Bereichen als mehrere Gruppen von Störstoffbereichen (5, 6, 7) aufgebaut sind, die in dem Halbleitersubstrat (8) angeordnet sind.

5. Festkörper - Farbbildaufnahmeeinrichtung nach einem der Ansprüche 1 bis 3, wobei die besagten in dem Halbleiterkörper enthaltenen mehreren Gruppen von lichtempfindlichen Bereichen eine photoleitende Schicht (222) aufweisen, die auf dem Halbleitersubstrat (201) angeordnet ist.

6. Festkörper - Farbbildaufnahmeeinrichtung nach einem der vorhergehenden Ansprüche, wobei auf einer oberen Fläche des Halbleiterkörpers eine lichtdurchlässige Polymerharzschicht (30) angeordnet ist, auf der mindestens die Farbfilterelemente (1, 2; 109, 110) liegen.

7. Verfahren zur Herstellung einer Festkörper-Farbbildaufnahmeeinrichtung, wobei auf einem mehrere Gruppen von lichtempfindlichen Bereichen (5, 6, 7; 222) aufweisenden Halbleiterkörper mindestens zwei Farbfilterelemente (1, 2; 109, 110) ausgebildet werden, bei der Ausbildung der Filterelemente ein photographischer Belichtungsvorgang verwendet wird, und wobei die Filterelemente mit jeweils unterschiedlichen spektralen Transmissionsfunktionen (23, 24) versehen und mindestens teilweise überlappend ausgebildet werden, um durch Kombination der spektralen Transmissionsfunktionen der beiden Filterelemente entsprechend einem der lichtempfindlichen Bereiche (6) eine dritte spektrale Transmissionsfunktion (22) zu erzeugen; dadurch gekennzeichnet, daß eines der Filterelemente (1), dessen spektrale Transmissionsfunktion (23) für die Belichtung benutztes Licht (33) im wesentlichen transmittiert, vor dem anderen Filterelement (2) so gebildet wird, daß es in dem Überlappungsbereich als das untere der beiden Filterelemente angeordnet wird.

8. Verfahren zur Herstellung einer Festkörper-Farbbildaufnahmeeinrichtung, wobei auf einem mehrere Gruppen von lichtempfindlichen Bereichen (5, 6, 7; 222) enthaltenden Halbleiterkörper ein lichtempfindlicher Film für ein Farbfilterelement ausgebildet wird, ein gewünschter Bereich des lichtempfindlichen Films mit Licht (33) belichtet und sodann zu einer Schicht (1, 2; 109, 110) gewünschter Gestalt für das Farbfilterelement entwickelt wird, die Schicht für das Farbfilterelement mit einer bestimmten spektralen Transmissionsfunktion (23) versehen wird, um das Farbfilterelement fertigzustellen, und das Farbfilterelement mit einer lichtdurchlässigen Zwischenschicht (3; 111) bedeckt wird, wobei die Vorgänge wiederholt werden, um nacheinander Farbfilterelemente (1, 2; 109, 110) mit jeweils bestimmten spektralen Transmissionsfunktionen (23, 24) auszubilden, wobei ferner als oberste Schicht eine Schutzschicht (4, 112) angeordnet wird, die jeweiligen spektralen Transmissionsfunktionen von mindestens zwei der Farbfilterelemente voneinander verschieden sind, das Farbfilterelement mit der ersten spektralen Transmissionsfunktion unter dem Farbfilterelement mit der zweiten spektralen Transmissionsfunktion liegt, und durch Kombination der ersten und der zweiten spektralen Transmissionsfunktion eine dritte spektrale Transmissionsfunktion erzeugt wird; dadurch gekennzeichnet, daß beim Stapeln des ersten und des zweiten Fitlerelements (1, 2; 109, 110) eines der Filterelemente (1, 109) mit einer spektralen Transmissionsfunktion (23), die das bei der Belichtung benutzte Licht (33) im wesentlichen transmittiert, als untere Schicht in dem gestapelten Aufbau angeordnet wird.

9. Verfahren zur Herstellung einer Festkörper-Farbbildaufnahmeeinrichtung nach Anspruch 7 oder 8, wobei das Licht (33) für die Belichtung im wesentlichen ultraviolette Strahlung ist und das als untere Schicht angeordnete Filterelement (1, 109) eine spektrale Transmissionsfunktion (23) aufweist, die die ultraviolette Strahlung im wesentlichen transmittiert.

10. Verfahren zur Herstellung einer Festkörper-Farbbildaufnahmeeinrichtung nach Anspruch 9, wobei als untere Schicht ein Cyan-Filterelement (1, 109) angeordnet wird, das eine die ultraviolette Strahlung im wesentlichen transmittierende spektrale Transmissionsfunktion (23) aufweist, während als obere Schicht ein Gelb-Filterelement (2, 110) angeordnet wird.

**Revendications**

1. Dispositif de formation d'images en couleurs à l'état solide, comportant un corps semiconducteur qui possède en lui-même plusieurs ensembles de régions photosensibles (5, 6, 7; 222) et au moins un premier et un second filtres colorés (1, 2; 109, 110) qui sont disposés sur le corps semiconducteur en correspondance avec les régions semiconductrices, les filtres colorés possédant au moins deux types de transmittances spectrales (23, 24) différentes l'une de l'autre et étant empilés l'un sur l'autre de manière à produire une troisième transmittance spectrale (22) correspondant à l'une des régions photosensibles (6) dans chaque ensemble desdites régions, par combinaison des transmittances spectrales des premier et second filtres, une exposition photographique étant utilisée pour la formation des filtres, caractérisé en ce que, dans l'empilage desdits premier et second filtres, celui des filtres (1), dont la transmittance spectrale (23) permet essentiellement la transmission de la lumière (33) utilisée pour ladite exposition, est disposé de manière à former une couche inférieure de la structure empilée.

2. Dispositif de formation d'images en couleurs à l'état solide selon la revendication 1, dans lequel la lumière (33) utilisée pour ladite exposition est essentiellement un rayonnement ultraviolet, et dans lequel ledit filtre (1) disposé de manière à former ladite couche inférieure possède une transmittance spectrale (23) qui permet essentiellement la transmission du rayonnement ultraviolet.

3. Dispositif de formation d'images en couleurs à l'état solide selon la revendication 2, dans lequel un filtre cyan (1) est disposé de manière à former ladite couche inférieure et possède une transmittance spectrale (23) qui permet essentiellement la transmission du rayonnement ultraviolet, tandis qu'un filtre jaune (2) est disposé de manière à former une couche supérieure.

4. Dispositif de formation d'images en couleurs à l'état solide, selon l'une quelconque des revendications 1 à 3, dans lequel plusieurs ensembles desdites régions photosensibles contenues dans ledit corps semiconducteur sont contitués sous la forme de plusieurs ensembles de régions d'impuretés (5, 6, 7) qui sont disposés dans un substrat semiconducteur (8).

5. Dispositif de formation d'images en couleurs à l'état solide selon l'une quelconque des revendications 1 à 3, dans lequel plusieurs ensembles de régions photosensibles contenues dans ledit corps semiconducteur possèdent une couche photoconductrice (222) qui est disposée sur un substrat semiconducteur (201).

6. Dispositif de formation d'images en couleurs à l'état solide selon l'une quelconque des revendications 1 à 5, dans lequel une couche de résine polymère (30) transmettant la lumière est disposée sur une surface supérieure dudit corps semiconducteur et est recouverte par au moins les filtres colorés (1, 2; 109, 110).

7. Procédé de fabrication d'un dispositif de formation d'images en couleurs à l'état solide, incluant une phase de formation d'au moins deux filtres colorés (1, 2; 109, 110) sur un corps semiconducteur possédant plusieurs ensembles de régions photosensibles (5, 6, 7; 222), un processus d'exposition photographique étant utilisé lors de la formation des filtres, auquel on donne des transmittances spectrales respectives (23, 24) différentes et qui sont formés en étant au moins partiellement en recouvrement, ce qui a pour effet de fournir une troisième transmittance spectrale (22) correspondant à l'une des régions photosensibles (6), par combinaison des transmittances spectrales desdits deux filtres, caractérisé en ce que l'un desdits filtres (1) dont la transmittance spectrale (23) permet essentiellement la transmission de la lumière (33) utilisée pour ladite exposition, est formé avant l'autre filtre (2) de manière à être disposé pour constituer celui des deux filtres, qui est inférieur, dans la zone de recouvrement.

8. Procédé de fabrication d'un dispositif de formation d'images en couleurs à l'état solide, incluant les phases opératoires consistant à former une pellicule photosensible pour un filtre coloré sur un corps semiconducteur comprenant plusieurs ensembles de régions photosensibles (5, 6, 7, 222), à exposer une zone désirée de la pellicule photosensible à une lumière (33), puis à la développer pour former une couche (1, 2; 109, 110) possédant une forme désirée pour le filtre coloré, à conférer à la couche utilisée pour le filtre coloré une transmittance spectrale prédéterminée (23) pour achever la réalisation du filtre coloré, et à recouvrir le filtre coloré par une couche intermédiaire (3, 111) transmettant la lumière, ces opérations étant répétées pour former successivement des filtres colorés (1, 2; 109, 110), possédant des transmittances spectrales respectives prédéterminées (23, 24), une couche protectrice (4, 112) étant disposée pour former la couche supérieure, les transmittances spectrales respectives d'au moins deux des filtres colorés étant différentes l'une de l'autre, le filtre coloré possédant la première transmittance spectrale étant recouvert par le filtre coloré possédant la seconde transmittance spectrale, et une troisième transmittance spectrale étant produite par une combinaison des première et seconde transmittance spectrales, caractérisé en ce que dans l'empilage desdits premier et second filtres (1, 2; 109, 110), l'un des filtres (1, 109), dont la transmittance spectrale (23) permet de transmettre essentiellement la lumière (33) utilisée pour l'exploitation, est disposée pour former une couche inférieure de la structure empilée.

9. Procédé de fabrication d'un dispositif de formation d'images en couleurs à l'état solide, selon la revendication 7 ou 8, dans laquelle ladite lumière (33) servant à l'exposition est essentiellement un rayonnement ultraviolet, et ledit filtre (1, 109) disposé de manière à former ladite couche inférieure possède une transmittance spectrale (23) qui permet essentiellement la transmission du rayonnement ultraviolet.

10. Procédé de fabrication d'un dispositif de formation d'images en couleurs à l'état solide selon la revendication 9, dans lequel un filtre cyan (1, 109) est disposé de manière à former ladite couche inférieure et possède une transmittance spectrale (23) qui permet essentiellement la transmission du rayonnement ultraviolet, tandis qu'un filtre jaune (2, 110) est disposé de manière à former une couche supérieure.

0 030 476

FIG. 1a

FIG. 1b

FIG. 1c

1

## FIG. 2

## FIG. 3

# FIG. 4